# EUROPÄISCHE PATENTSCHRIFT

(11) **EP 2 256 819 B1**
(45) Veröffentlichungstag und Bekanntmachung des Hinweises auf die Patenterteilung: **06.09.2017**
(21) Anmeldenummer: 10005370.1
(22) Anmeldetag: 21.05.2010
(51) Int. Cl.: H01L 31/02, H02S 40/34

(54) **Anschlussdose für ein Solarmodul und ein Solarpaneel**
Connection socket for a solar module and a solar panel
Boîte de jonction pour un module solaire et un panneau solaire

(30) Priorität: 25.05.2009 DE 202009007318 U; 06.08.2009 DE 202009011982 U; 20.11.2009 DE 102009054039
(43) Veröffentlichungstag der Anmeldung: 01.12.2010
(73) Patentinhaber: Yamaichi Electronics Deutschland GmbH, 85609 Aschheim-Dornach (DE)
(72) Erfinder: Michel, Dirk, 85716 Unterschleißheim (DE)
(74) Vertreter: Müller-Boré & Partner Patentanwälte PartG mbB

(56) Entgegenhaltungen:
- EP-A1- 1 777 754
- WO-A2-2007/048421
- DE-U1-202005 014 032

## Beschreibung

Die Erfindung betrifft eine Anschlußdose für ein Solarmodul und ein Solarpaneel.

Herkömmliche Solarmodule zur Erzeugung elektrischer Energie aus Sonnenlicht umfassen eine oder mehrere einzelne Solarzellen. Je nach gewünschter vom Solarmodul zur Verfügung zu stellenden Spannung und/oder Stromstärke werden einzelne Solarzellen innerhalb des Moduls parallel und/oder in Reihe geschaltet und damit zu Solarzellengruppen zusammengefaßt. Die Solarzellengruppen werden zu einem flachen Solarmodul zusammengefaßt. Die elektrischen Anschlüsse der Solarzellengruppen des Solarmoduls werden nach außen geführt.

Bei partieller Verringerung der Bestrahlungsintensität durch Sonnenlicht auf einzelne Solarzellen bzw. Solarzellengruppen, beispielsweise durch Verschmutzung oder Schattenwurf, können unter anderem folgende Effekte auftreten: (1) Eine (gleichmäßige) Verringerung der Bestrahlungsintensität innerhalb der zusammen geschalteten Solarzellengruppen führt zu einer Leistungsverminderung der jeweiligen Solarzellengruppe. (2) Durch eine partielle Abschattung einer Solarzelle innerhalb einer Solarzellengruppe wirkt diese abgeschattete Solarzelle als Sperrdiode bzw. Widerstand innerhalb des Stromkreises der Solarzellengruppe, was zum einen dazu führen kann, daß die gesamte Solarzellengruppe keine elektrische Energie mehr liefern kann und zum anderen zu einer Beschädigung der abgeschatteten Solarzelle und damit zum dauerhaften Ausfall der Solarzellengruppe führen kann. In jedem Fall können zwischen den herausgeführten Anschlüssen der Solarzellengruppen eines Solarmoduls, je nach Bestrahlungsintensität auf die einzelnen Solarzellen, unterschiedliche Spannungen anliegen. Eine Reihenschaltung der Solarzellengruppen durch entsprechende Schaltung der nach außen geführten Anschlüsse führt analog zu den oben genannten Problemen.

Um die mit der unterschiedlichen Bestrahlungsintensität der Solarzellen verbundenen Probleme zu vermeiden, werden herkömmlich sogenannte Bypass-Dioden, verwendet, die elektrisch antiparallel zu den Solarzellengruppen geschaltet werden. Diese Bypass-Dioden haben die Wirkung, daß der Stromfluß durch das Solarmodul an Solarzellengruppen, welche eine nur geringe Leistung liefern, vorbei geleitet wird, d.h. die Anschlüsse dieser Solarzellengruppe eines Solarmoduls werden durch die Bypass-Diode kurz geschlossen und die entsprechende Solarzellengruppe dadurch überbrückt. Somit liefert eine solche Solarzellengruppe zwar keinen Anteil mehr zur Gesamtleistung des Solarmoduls, der Gesamtstromfluß durch das Solarpaneel ist jedoch im wesentlichen ungehindert und eine Beschädigung einzelner Solarzellen wird verhindert.

Solarpaneele, umfassen daher neben dem Solarmodul in der Regel eine elektrische Anschlußdose mit zumindest zwei Kontaktvorrichtungen und zumindest einer Bypass-Diode. Die Solarzellen in einem Solarmodul sind in der Regel durch flache dünne Leiterbänder miteinander verbunden. Diese Leiterbänder werden aus dem Solarmodul heraus geführt und mit einem in der Anschlußdose angeordneten elektrischen Leiterkontakt verbunden. Um die von dem Solarmodul erzeugte elektrische Energie einem Verbraucher zur Verfügung zu stellen, weist die Anschlußdose zwei Anschlußpole auf, d.h. einen Plus- und einen Minuspol zwischen denen im Betrieb eine elektrische Spannung anliegt. Das mit der Anschlußdose versehene Solarmodul wird als Solarpaneel bezeichnet.

Während des Betriebes und bei Anschließen bzw. Abklemmen eines Solarpaneels können aufgrund induzierter Ströme, beispielsweise aufgrund von Gewittern oder Leitungsinduktivitäten, Spannungsspitzen an den Solarzellen bzw. den Bypass-Dioden anliegen und diese beschädigen oder völlig zerstören. Daher ist die Betriebssicherheit und die Lebensdauer des Solarpaneels durch derartige Spannungsspitzen verringert.

Die Druckschrift EP 1 777 754 A1 offenbart eine Anschlußdose für ein Solarmodul mit einer Vielzahl von elektrische Kontaktvorrichtungen zum Kontaktieren elektrischer Leiter des Solarmoduls und einer Vielzahl von Bypass-Dioden, welche jeweils zwei benachbarte Kontaktvorrichtungen elektrisch verbinden.

Die Druckschrift DE 20 2005 014 032 U1 offenbart eine solarbetriebene Spannungstreiberstufe für den Betrieb von Solarmotoren.

Es ist eine Aufgabe der Erfindung, eine elektrische Anschlußdose und ein Solarpaneel bereitzustellen, welche eine erhöhte Betriebssicherheit Betriebssicherheit bei Beaufschlagung mit Überspannungen aufweist.

Die Aufgabe wird durch die elektrische Anschlußdose gemäß Anspruch 1 sowie das Solarpaneel gemäß Anspruch 10 gelöst. Bevorzugte Ausführungsformen sind Gegenstand der abhängigen Ansprüche.

### Anschlußdose gemäß einem Aspekt

Ein Aspekt der vorliegenden Erfindung betrifft eine Anschlußdose für ein Solarmodul umfassend:
- einen elektrischen Anschlußminuspol und einen elektrischen Anschlußpluspol,
- zumindest zwei elektrische Kontaktvorrichtungen,
   -- wobei jede der zumindest zwei elektrischen Kontaktvorrichtungen mit einem zugeordneten elektrischen Leiter des Solarmoduls kontaktierbar ist und
   -- wobei zumindest zwei der zumindest zwei Kontaktvorrichtungen als Leiterplatte ausgebildet sind,
- zumindest eine Bypass-Diode und
- zumindest ein Überspannungsschutzelement,
wobei die zumindest eine Bypass-Diode zwei der Kontaktvorrichtungen elektrisch verbindet, und
wobei das zumindest eine Überspannungsschutzelement parallel zu zumindest einer der zumindest einen Bypass-Diode geschaltet ist,
wobei die Ansprechzeit des zumindest einen Überspannungsschutzelementes kleiner ist als die Ansprechzeit der Bypass-Dioden, um die zumindest eine Bypass-Diode vor Überspannungen zu schützen.

In anderen Worten ist die erste der zumindest zwei elektrischen Kontaktvorrichtungen mit dem ersten elektrischen Leiter des Solarmoduls kontaktierbar und ist die zweite der zumindest zwei elektrischen Kontaktvorrichtungen mit dem zweiten elektrischen Leiter des Solarmoduls kontaktierbar.

Die Kontaktvorrichtungen sind als Leiterplatte ausgebildet, also aus einem plattenförmigen, elektrisch leitfähigen Element. Vorteilhafterweise können die notwendigen elektronischen Bauteile durch Löten, Schweißen, Kleben, usw. einfach und sicher an der Leiterplatte befestigt werden. Beispielsweise kann die Leiterplatte ein Stanzbauteil sein, insbesondere ein Blechbauteil sein, beispielsweise aus Kupfer-, Eisen-, Metallegierungsblech, mit oder ohne einer Metallbeschichtung, das in die gewünschte Form gestanzt ist. Bevorzugt kann die Leiterplatte aus einem Metallblech von 0,1 mm bis 2 mm Dicke, weiter bevorzugt von 0,2 mm bis 1 mm Dicke, gefertigt sein. Weiter vorteilhafterweise weist die Leiterplatte eine für Metalle typische hohe Wärmekapazität und Wärmeleitfähigkeit auf, so daß die durch den stromflußbedingte thermische Energie, welche insbesondere an den Bypass-Diode und/oder den Überspannungsschutzelementen entsteht, einfach über die Leiterplatte abgeführt werden kann.

Der Anschlußminuspol und Anschlußpluspol sind ausgelegt, ein an die Anschlußdose angeschlossenes Solarmodul mit einem elektrischen Verbraucher zu verbinden. Da das Solarmodul eine Gleichspannung erzeugt, kann der Anschlußminuspol mit "-" bzw. als Minuspol und der Anschlußpluspol mit "+" bzw. als Pluspol bezeichnet werden. Im Betrieb fließt innerhalb der Anschlußdose und des Solarmoduls, d.h. innerhalb der Stromquelle, der Strom I entlang der technischen Stromrichtung vom Minuspol zum Pluspol.

Das Solarmodul, welches ausgelegt ist mit der Anschlußdose zu kontaktieren, weist zumindest zwei elektrische Leiter auf, wobei die zumindest zwei elektrischen Kontaktvorrichtungen der Anschlußdose ausgelegt sind mit einem Solarmodul mit zumindest zwei elektrischen Leitern kontaktierbar zu sein.

Die Anschlußdose weist ferner zumindest eine Bypass-Diode auf, wobei die Bypass-Diode jeweils zwei der zumindest zwei elektrischen Kontaktvorrichtungen miteinander elektrisch verbindet. Dabei ist die Bypass-Diode ausgelegt eine niederohmige Verbindung bzw. einen Kurzschluß zwischen den entsprechenden zwei Kontaktvorrichtungen herzustellen, welche durch die Bypass-Diode verbunden werden, wenn zwischen diesen zwei Kontaktvorrichtungen eine vorbestimmbare Spannung anliegt. In diesem Fall, d.h. wenn die Spannung zwischen den zwei Kontaktvorrichtungen einen vorbestimmbaren Schwellwert überschreitet, so überschreitet auch die über die Bypass-Diode abfallenden Spannung diesen Schwellwert. Dadurch verliert die Bypass-Diode ihre Sperrwirkung und stellt einen Kurzschluß zwischen den zwei Kontaktvorrichtungen her.

Vorteilhafterweise fließt im Betrieb der Gesamtstrom in diesem Fall nicht über das Solarmodul, sondern über die Bypass-Diode, wodurch in dem angeschlossenen Solarmodul kein elektrischer Leistungsverlust bzw. keine Erwärmung auftritt. Das Überschreiten der vorbestimmbaren Spannung zwischen zwei Kontaktvorrichtungen kann im Betrieb dadurch auftreten, daß eine Solarzellengruppe des Solarmoduls, welche an den zwei elektrischen Kontaktvorrichtungen der Anschlußdose angeschlossen ist, abgeschattet wird und daher keine ausreichende elektrische Leistung erzeugt.

Die Anschlußdose umfaßt weiter zumindest ein Überspannungsschutzelement, welches zumindest zu einer der zumindest einen Bypass-Dioden parallel geschaltet ist.

Ein Überspannungsschutzelement ist ein Element, bevorzugt eine Halbleiterdiode wie z.B. eine Supressor-Diode, eine bipolare Supressor-Diode, eine Zener-Diode oder eine Schottky-Diode oder eine Crowbar-Diode oder ein Varistor oder ein Transistor Voltage Suppressor, das zum Schutz vor Überspannungen bzw. unerlaubten Spannungen eingesetzt wird. Überspannungen können beispielsweise aufgrund von Induktivitäten der Anschlußdose, des daran angeschlossenen Solarmoduls und/oder des an den Anschlußpolen angeschlossenen Verbrauchers bzw. den zu diesem führenden elektrischen Leitungen auftreten. Überspannungen können insbesondere auftreten, sobald eine elektrische Leitung getrennt wird.

Eine Bypass-Diode kann eine Schottky-Diode oder eine andere Art von Diode sein, wie z.B. eine Supressor-Diode, eine bipolare Supressor-Diode, eine Zener-Diode oder eine Schottky-Diode oder eine Crowbar-Diode, oder ein Varistor oder ein Transistor Voltage Suppressor.

Zum Schutz vor einer Überspannung beim Abschalten einer induktiven Gleichspannungslast, wird das Überspannungsschutzelement (im Falle einer Halbleiterdiode auch Freilauf-Diode genannt) derart parallel zu dem induktiven Element geschaltet, daß sie von dem im Betrieb fließenden Strom I in Sperrichtung beansprucht werden.

Beim Lösen von mit den Anschlußpolen kontaktierenden elektrischen Leitungen, beispielsweise bei Montagearbeiten an dem Solarpaneel, wird der im Betrieb ausgebildete Stromkreis unterbrochen, wobei aufgrund der Selbstinduktion eines induktiven Elementes ein Stromfluß in der ursprünglichen Richtung des Stromes I erzeugt wird. Ohne Überspannungsschutzelement führt das zu einer Spannungsspitze, die sich zur Betriebsspannung addiert und die elektronischen Bauteile schädigen oder zerstören kann. Vorteilhafterweise wird aufgrund des Überspannungsschutzelementes die Spannungsspitze jedoch auf die Durchlaßspannung des Überspannungsschutzelementes begrenzt. Das schützt die elektronischen Bauteile vorteilhafterweise vor Überspannung, da der Strom über das Überspannungsschutzelement fließt.

Der Begriff "Kontakt" im Sinne der vorliegenden Erfindung beinhaltet insbesondere elektrischen und/oder mechanischen Kontakt.

### Bevorzugte Ausführungsformen der Anschlußdose

Es versteht sich, daß die Anschlußdose auch zumindest drei oder zumindest vier elektrische Kontaktvorrichtung aufweisen kann, wobei eine jede der zumindest drei oder zumindest vier elektrischen Kontaktvorrichtungen mit einem zugeordneten elektrischen Leiter des Solarmoduls kontaktierbar ist. Dementsprechend kann die Anschlußdose auch zumindest zwei oder zumindest drei Bypass-Dioden aufweisen.

In anderen Worten kann die dritte der zumindest drei elektrischen Kontaktvorrichtungen mit dem dritten elektrischen Leiter des Solarmoduls und gegebenenfalls die vierte der zumindest vier elektrischen Kontaktvorrichtungen mit dem vierten elektrischen Leiter des Solarmoduls kontaktierbar sein. Weiter kann die zweite der zumindest zwei Bypass-Dioden die zweite Kontaktvorrichtung mit der dritten Kontaktvorrichtung elektrisch verbinden. Gegebenenfalls kann die dritte der zumindest drei Bypass-Dioden die dritte Kontaktvorrichtung mit der vierten Kontaktvorrichtung elektrisch verbinden.

Vorzugsweise verbindet genau ein Überspannungsschutzelement den Anschlußminuspol mit dem Anschlußpluspol elektrisch. Insbesondere ist das Überspannungsschutzelement zu allen Bypass-Dioden parallel geschaltet. Bevorzugt ist das Überspannungsschutz-Diode unmittelbar mit dem Anschlußminuspol und/oder dem Anschlußpluspol kontaktiert, insbesondere verlötet. Vorteilhafterweise ist lediglich ein Überspannungsschutzelement notwendig, um alle Bypass-Dioden zu schützen, wodurch der Montageaufwand und der Materialverbrauch vorteilhafterweise gering gehalten ist.

Vorzugsweise umfaßt die Anschlußdose:
- N elektrische Kontaktvorrichtungen, welche jeweils mit einem zugeordneten elektrischen Leiter des Solarmoduls kontaktierbar sind,
- N-1 Bypass-Dioden und
- N-1 Überspannungsschutzelemente,
wobei jeweils zwei elektrische Kontaktvorrichtungen durch eine Bypass-Diode und ein dazu parallel geschaltetes Überspannungsschutzelement elektrisch verbunden sind.

Vorteilhafterweise ist zu jeder Bypass-Diode eine zugeordnetes Überspannungsschutzelement parallel geschaltet, so daß jede Bypass-Diode einzeln geschützt ist. Die Anzahl N der elektrischen Kontaktvorrichtungen kann dabei 3, 4, 5, 6, 7, 8, 9, 10 oder jede weitere natürliche Zahl sein, so daß die Anzahl N-1 der Bypass-Dioden 2, 3, 4, 5, 6, 7, 8, usw. ist.

Vorzugsweise weisen zumindest zwei der Kontaktvorrichtungen, die als Leiterplatte ausgebildet sind, einen zumindest bereichsweise eben ausgebildeten anschlußpluspolseitigen Kurzschlußbereich und/oder einen zumindest bereichsweise eben ausgebildeten anschlußminuspolseitigen Kurzschlußbereich auf.

Unter dem Begriff "anschlußminuspolseitig" wird im folgenden verstanden, daß der Kurzschlußbereich bzw. Überspannungskurzschlußbereich einer Kontaktvorrichtungen räumlich und/oder stromfließrichtungsmäßig in Richtung des Anschlußminuspols angeordnet ist. Dementsprechend beschreibt der Begriff "anschlußpluspolseitig" im folgenden, daß der Kurzschlußbereich bzw. Überspannungskurzschlußbereich einer Kontaktvorrichtungen räumlich und/oder stromfließrichtungsmäßig in Richtung des Anschlußpluspols angeordnet ist.

Es versteht sich, daß die Kontaktvorrichtung, welche den Anschlußminuspol aufweist, lediglich einen anschlußpluspolseitigen Kurzschlußbereich aufweisen kann. Dementsprechend kann die Kontaktvorrichtung, welche den Anschlußpluspol aufweist, lediglich einen anschlußminuspolseitigen Kurzschlußbereich aufweisen. Die weiteren Kontaktvorrichtungen können einen anschlußpluspolseitigen Kurzschlußbereich und/oder einen anschlußminuspolseitigen Kurzschlußbereich aufweisen, welche jeweils zumindest bereichsweise eben oder vollständig eben ausgebildet sein können.

Alternativ oder zusätzlich weisen zumindest zwei der Kontaktvorrichtungen, die als Leiterplatte ausgebildet sind, einen zumindest bereichsweise eben ausgebildeten anschlußpluspolseitigen Überspannungskurzschlußbereich und/oder einen zumindest bereichsweise eben ausgebildeten anschlußminuspolseitigen Überspannungskurzschlußbereich auf.

Es versteht sich, daß die Kontaktvorrichtung, welche den Anschlußminuspol aufweist, lediglich einen anschlußpluspolseitigen Überspannungskurzschlußbereich aufweisen kann. Dementsprechend kann die Kontaktvorrichtung, welche den Anschlußpluspol aufweist, lediglich einen anschlußminuspolseitigen Überspannungskurzschlußbereich aufweisen. Die weiteren Kontaktvorrichtungen können einen anschlußpluspolseitigen Überspannungskurzschlußbereich und/oder einen anschlußminuspolseitigen Überspannungskurzschlußbereich aufweisen, welche jeweils zumindest bereichsweise eben oder vollständig eben ausgebildet sein können.

Die am Rande auf beiden Seiten der nacheinander angeordneten Kontaktvorrichtungen befindlichen Kontaktvorrichtungen können jeweils entweder einen zumindest bereichsweise eben ausgebildeten anschlußpluspolseitigen Kurzschlußbereich oder einen zumindest bereichsweise eben ausgebildeten anschlußminuspolseitigen Kurzschlußbereich aufweisen. Ferner können diese am Rande befindlichen Kontaktvorrichtungen jeweils entweder einen zumindest bereichsweise eben ausgebildeten anschlußpluspolseitigen Überspannungskurzschlußbereich oder einen zumindest bereichsweise eben ausgebildeten anschlußminuspolseitigen Überspannungskurzschlußbereich aufweisen.

Die Kurzschlußbereiche und/oder die Überspannungskurzschlußbereiche können als taschenförmige Vertiefungen eines ansonsten im Wesentlichen ebenen Bereichs der jeweiligen Kontaktvorrichtungen ausgebildet sein. Die Bereiche an denen die Kurzschlußbereiche und/oder die Überspannungskurzschlußbereiche angeordnet sind, können gegenüber den übrigen Bereichen der jeweiligen der jeweiligen Kontaktvorrichtungen abgewinkelt, insbesondere rechtwinklig, angeordnet sein. Dies gilt insbesondere im Verhältnis zu den zumindest zwei der Kontaktvorrichtungen, die als Leiterplatte ausgebildet sind.

Vorzugsweise ist jeder der anschlußpluspolseitigen Kurzschlußbereiche parallel und gegenüberliegend zu einem zugeordneten anschlußminuspolseitigen Kurzschlußbereich der benachbarten Kontaktvorrichtung angeordnet. Weiter vorzugsweise ist jeder der anschlußpluspolseitigen Überspannungskurzschlußbereiche parallel und gegenüberliegend zu einem zugeordneten anschlußminuspolseitigen Überspannungskurzschlußbereich der benachbarten Kontaktvorrichtung angeordnet.

Vorteilhafterweise kann eine Bypass-Diode, insbesondere in Form eines SMD-Bauteils, in einfacher Weise und mit einem geringen Übergangswiderstand mit dem anschlußminuspolseitigen und/oder anschlußpluspolseitigen Kurzschlußbereich kontaktieren. Insbesondere wenn der Kurzschlußbereich zumindest bereichsweise, nämlich im Bereich des elektrischen Kontaktes zwischen der Bypass-Diode, d.h. einem ersten oder zweiten Anschlußkontakt der Bypass-Diode, und dem Kurzschlußbereich eben ausgebildet ist, kann die Bypass-Diode mit dem Kurzschlußbereich spaltfrei mechanisch kontaktieren, so daß ein geringer elektrischer Übergangswiderstand ausgebildet ist. Das heißt, daß die Bypass-Diode im Bereich des elektrischen Kontaktes im wesentlichen flächig an dem anschlußminuspolseitigen bzw. anschlußpluspolseitigen Kurzschlußbereich anliegt. Bevorzugt kann der anschlußminuspolseitige und/oder der anschlußpluspolseitige Kurzschlußbereich elastisch rückstellfähig ausgebildet sein, so daß eine vorbestimmbare Andruckkraft an die Bypass-Diode angelegt werden kann, wenn die Bypass-Diode an dem anschlußminuspolseitigen bzw. anschlußpluspolseitigen Kurzschlußbereich angeordnet ist. Bevorzugt kann ein elektrischer Kontakt unmittelbar zwischen dem ersten Anschlußkontakt der Bypass-Diode und dem anschlußminuspolseitigen Kurzschlußbereich ausgebildet sein. Weiter bevorzugt ein elektrischer Kontakt unmittelbar zwischen dem zweiten Anschlußkontakt der Bypass-Diode und dem anschlußpluspolseitigen Kurzschlußbereich ausgebildet sein. Besonders bevorzugt ist die Bypass-Diode zwischen dem anschlußminuspolseitigen und anschlußpluspolseitigen Kurzschlußbereich eingeklemmt bzw. festgelegt.

Es versteht sich, daß der elektrische Kontakt zwischen dem ersten Anschlußkontakt der Bypass-Diode und dem anschlußminuspolseitigen Kurzschlußbereich bzw. zwischen dem zweiten Anschlußkontakt der Bypass-Diode und dem anschlußpluspolseitigen Kurzschlußbereich auch mittelbar ausgebildet sein kann. Besonders bevorzugt ist der mittelbare elektrische Kontakt über ein Lötmittel hergestellt. Weiter bevorzugt kann der anschlußminuspolseitigen Kurzschlußbereich und/oder der anschlußpluspolseitigen Kurzschlußbereich ein Lötmitteldepot umfassen. Vorteilhafterweise ist die Montage der Bypass-Diode vereinfacht, da die Bypass-Diode zwischen dem anschlußminuspolseitigen Kurzschlußbereich und dem anschlußpluspolseitigen Kurzschlußbereich angeordnet oder festgeklemmt werden kann, um anschließend durch Wärmeeinwirkung mittels des Lötmitteldepots verlötet zu werden.

Es versteht sich, daß die obigen Ausführungen bezüglich der Bypass-Diode(n) und den anschlußminuspolseitigen und anschlußpluspolseitigen Kurzschlußbereichen in analoger Weise auf das/die Überspannungsschutzelement(e) und die anschlußminuspolseitigen und anschlußpluspolseitigen Überspannungskurzschlußbereiche übertragbar sind.

Vorzugsweise kann zumindest einer der anschlußpluspolseitigen Kurzschlußbereiche ein Lötmitteldepot aufweisen. Weiter bevorzugt kann zumindest einer der anschlußminuspolseitigen Kurzschlußbereiche ein Lötmitteldepot aufweisen. Bevorzugt kann zumindest einer der anschlußpluspolseitigen Überspannungskurzschlußbereiche ein Lötmitteldepot aufweisen. Weiter bevorzugt kann zumindest einer der anschlußminuspolseitigen Überspannungskurzschlußbereiche ein Lötmitteldepot aufweisen.

Vorzugsweise gilt für alle geradzahligen n mit 1 < n ≤ N und N größer oder gleich 3 folgendes: Eine (n-1)-te Bypass-Diode, welche die (n-1)-te Kontaktvorrichtung mit der n-ten Kontaktvorrichtung elektrisch verbindet, ist entlang einer Richtung X oder Y von einem (n-1)-ten Überspannungsschutzelement, welches die (n-1)-te Kontaktvorrichtung mit der n-ten Kontaktvorrichtung elektrisch verbindet, beabstandet.

Weiter vorzugsweise gilt für alle geradzahligen n mit 1 < n < N und N größer oder gleich 3 folgendes: Eine n-te Bypass-Diode, welche die (n+1)-te Kontaktvorrichtung mit der n-ten Kontaktvorrichtung elektrisch verbindet, ist entgegen der Richtung X oder Y von einem n-ten Überspannungsschutzelement, welches die (n+1)-te Kontaktvorrichtung mit der n-ten Kontaktvorrichtung elektrisch verbindet, beabstandet.

Die Zahl n kann also 2, 4, 6, 8, 10 usw. betragen. Mit anderen Worten kann, beispielhaft ausgehend von N=5 und n=2 also der zweiten Kontaktvorrichtung, die erste Bypass-Diode entlang der Richtung X von dem ersten Überspannungsschutzelement beabstandet angeordnet sein. Das heißt, daß sich die erste Bypass-Diode ausgehend von dem ersten Überspannungsschutzelement in Richtung X befindet. Dagegen kann die zweite Bypass-Diode entgegen der Richtung X von dem zweiten Überspannungsschutzelement beabstandet angeordnet sein. Das heißt, daß sich das zweite Überspannungsschutzelement ausgehend von der zweiten Bypass-Diode in Richtung X befindet.

Die relative Position der dritten Bypass-Diode zu dem dritten Überspannungsschutzelement kann dann der relativen Position der ersten Bypass-Diode zu dem ersten Überspannungsschutzelement entsprechen. Dementsprechend kann die relative Position der vierten Bypass-Diode zu dem vierten Überspannungsschutzelement der relativen Position der zweiten Bypass-Diode zu dem zweiten Überspannungsschutzelement entsprechen.

Mit anderen Worten kann die relative Position der Bypass-Diode zu dem zugeordneten Überspannungsschutzelement von Kontaktvorrichtung zu Kontaktvorrichtung alternierend sein. Vorteilhafterweise sind die paarweisen Abstände der einzelnen Bypass-Dioden zueinander (und auch der einzelnen Überspannungsschutzelemente zueinander) gegenüber einer nicht alternierenden Anordnung vergrößert. Vorteilhafterweise kann die in den Bypass-Dioden und/oder den Überspannungsschutzelementen erzeugte thermische Energie über einen vergrößerten Bereich der Leiterplatte verteilt werden, wodurch die gegenseitige thermische Belastung der Bypass-Dioden und Überspannungsschutzelemente untereinander verringert ist.

Vorzugsweise ist das zumindest eine Überspannungsschutzelementelement eine Supressor-Diode, eine bipolare Supressor-Diode, eine Zener-Diode, eine Schottky-Diode, ein Varistor oder ein Transistor Voltage Supressor. Hierbei ist es nicht notwendig, daß bei einer Mehrzahl Überspannungsschutzelemente alle Überspannungsschutzelemente vom gleichen Typ sind. Vielmehr ist es möglich, daß Überspannungsschutzelemente verschiedenen Typs bzw. verschiedener Art in ein und der selben Anschlußdose eingesetzt werden.

Vorzugsweise sind zumindest zwei der elektrischen Kontaktvorrichtungen ausschließlich mittels zumindest einer Bypass-Diode und/oder zumindest eines Überspannungsschutzelementes mechanisch verbunden.

Beispielsweise können die zwei Kontaktvorrichtungen diskrete voneinander getrennte Bauteile sein, an welche die Bypass-Diode bzw. das Überspannungsschutzelement befestigt, insbesondere gelötet, ist bzw. sind, so daß beide Kontaktvorrichtungen mechanisch miteinander verbunden sind. Hierbei ist es möglich, daß die zwei Kontaktvorrichtungen ursprünglich aus einem Bauelement bestanden und nach Anordnung der Dioden zu zwei Kontaktvorrichtungen vereinzelt wurden, insbesondere mittels Durchtrennen einer Solltrennstelle.

Bevorzugt ist ein Gehäuse der Anschlußdose spritzgegossen, wobei die Bypass-Dioden und das/die Überspannungsschutzelement(e) in dem Gehäusematerial der Anschlußdose eingebettet sind und von dem Gehäusematerial der Anschlußdose umgeben sind. Vorzugsweise wird beim Spritzgießen des Gehäuses flüssiges, insbesondere thermisch geschmolzenes Gehäusematerial verwendet. Die Schmelztemperatur des Gehäusematerials beträgt hierbei zwischen etwa 250°C und etwa 400°C, bevorzugt zwischen etwa 300°C und etwa 380°C, insbesondere zwischen etwa 300°C und etwa 350°C. Das geschmolzene Gehäusematerial wird auf bzw. um die Bypass-Dioden und das/die Überspannungsschutzelement(e) gespritzt. Da die Bypass-Dioden und die Überspannungsschutzelemente den Kontaktvorrichtungen angeordnet sind, wird das geschmolzene Gehäusematerial zumindest bereichsweise auch um die Kontaktvorrichtungen bzw. die Leiterplatten gespritzt. Somit werden die die Bypass-Dioden, die Überspannungsschutzelemente und zumindest ein Bereich der Kontaktvorrichtungen bzw. der Leiterplatten vollständig von dem geschmolzenen Gehäusematerial umgeben und in dieses eingebettet und somit insbesondere feuchtigkeitsdicht von der Umgebung abschlossen. Das geschmolzene Gehäusematerial kühlt anschließend aus und erstarrt, wobei das Gehäuse gebildet wird. Die Anschlußdose kann zu einem späteren Zeitpunkt an einem Solarmodul angeordnet und angeschlossen werden. Gegebenenfalls kann ein Hohlraum bzw. eine Öffnung in dem Gehäuse, der zum Anschluß der Anschlußdose an dem Solarmodul notwendig ist mit Kunstharz ausgegossen werden und/oder es kann ein Deckel an dem Gehäuse angeordnet werden.

Überraschenderweise wurde festgestellt, daß die Bypass-Dioden bzw. die Überspannungsschutzelemente von dem geschmolzenen Gehäusematerial umgeben und in dieses eingebettet sein können, obwohl die maximale Betriebstemperatur dieser elektrischen Bauteile wesentlich niedriger ist, insbesondere im Bereich zwischen etwa 100°C und etwa 200°C, insbesondere zwischen etwa 130°C und etwa 170°C liegt. Ferner wurde überraschenderweise festgestellt, daß im Betrieb der Anschlußdose die durch die Bypass-Dioden erzeugte Wärme ausreichend aus der Anschlußdose abgeleitet werden kann, obwohl die Bypass-Dioden in das Gehäusematerial eingebettet sind. Somit kann die Anschlußdose in sehr einfacher und kosteneffizienter Weise hergestellt werden, da als Kontaktvorrichtungen bzw. als Leiterplatte Stanzbauteile verwendet werden können, das Gehäuse nicht vorgefertigt werden muß und die elektrischen Bauelemente, d.h. die Kontaktvorrichtungen bzw. die Leiterplatte und die Bypass-Dioden bzw. die Überspannungsschutzelemente nicht in einem vorgefertigten Gehäuse angeordnet werden müssen. Vielmehr können in einfacher Weise die Bypass-Dioden bzw. die Überspannungsschutzelemente an den Kontaktvorrichtungen bzw. der Leiterplatte angeordnet werden, gegebenenfalls Kontakte an den Kontaktvorrichtungen bzw. der Leiterplatte unterbrochen werden, wobei hierfür z.B. Sollbruchstellen vorgesehen sein können, und die mit den Bypass-Dioden bzw. den Überspannungsschutzelementen bestückten Kontaktvorrichtungen bzw. Leiterplatten mit geschmolzenem Gehäusematerial umgeben werden. Insbesondere können die Kontaktvorrichtungen durch Trennen einer einzigen Master-Leiterplatte hergestellt werden. Das Anordnen des Gehäusematerials kann bei hohem Druck und hoher Temperatur erfolgen.

Der Begriff "feuchtigkeitsdicht", wie er in dieser Anmeldung verwendet wird, beinhaltet, daß insbesondere keine Leck- bzw. Kriechströme durch Eindringen von Feuchtigkeit aus dem Inneren der Anschlußdose nach Außen, d.h. an die Umgebung dringen können. Der Begriff "feuchtigkeitsdicht", wie er in dieser Anmeldung verwendet wird, beschreibt somit insbesondere, daß die Anschlußdose insbesondere eine Feuchtigkeitsprüfung gemäß IP 67, besonders bevorzugt IP 68 besteht.

Der Begriff "feuchtigkeitsdicht" wie er im Sinne der vorliegenden Anmeldung verwendet wird, kann eine Dichtheit bzw. eine Barriere gegenüber einem Fluid, insbesondere Wasser und/oder Wasserdampf beschreiben, wobei insbesondere ein Widerstandswert von 400 MΩ gegenüber dem elektrisch leitfähigen Fluid gemäß der IEC 61215 Sektion 10.15 aufrecht erhalten bleibt. Feuchtigkeitsdichtheit wird erreicht, wenn die Migration, d.h. das Fließen bzw. Verlagern der Feuchtigkeit aufgrund einer Partialdruckdifferenz bzw. der Druckdifferenz (insbesondere bei einer Druckdifferenz von etwa 10kPa) bzw. der Diffusion verhindert bzw. hinreichend verlangsamt wird. Hinreichend langsam bedeutet insbesondere, daß die Fließgeschwindigkeit des Fluids in einem Körper innerhalb von Poren oder entlang von kanalförmigen der flächigen präferentiellen Fließwegen vorzugsweise einen Wert von etwa 1m pro Stunde, von etwa 1cm pro Stunde, von etwa 1mm pro Tag, weiter bevorzugt etwa 1 mm pro Jahr, besonders bevorzugt 0,1 mm pro Jahr, insbesondere 0,01 mm pro Jahr nicht überschreitet.

In anderen Worten wird durch das Einbetten der Bypass-Dioden bzw. der Überspannungsschutzelemente in das Gehäusematerial ein Eindringen von Feuchtigkeit in das Innere der Anschlußdose, insbesondere zu den Dioden und/oder zu den elektrischen Kontaktvorrichtungen hin verhindert. Somit wird erreicht, daß die Anschlußdose eine hohe Feuchtigkeitsdichte, insbesondere gemäß IP 67, besonders bevorzugt IP 68 aufweist, und dies bei einer sehr kompakten Baugröße.

Bevorzugt ist das Überspannungsschutzelement und/oder die Bypass-Diode als SMD-Bauteil ausgebildet. Insbesondere in Anschlußdosen, die mit Kunstharz ausgegossen sind, weisen SMD Bauteile bessere thermische Eigenschaften auf, da sie im Gegensatz zu Bauteilen in axialer Bauweise eine größere Oberfläche aufweisen, über die Wärme an das umgebende Kunstharz abgegeben werden kann. Vorteilhafterweise gilt dies auch, wenn das SMD-Bauteil in das Gehäusematerial eingebettet ist.

### Solarpaneel gemäß einem Aspekt

Ein weiterer Aspekt der vorliegenden Erfindung betrifft ein Solarpaneel umfassend:
- zumindest ein im wesentlichen plattenförmiges Solarmodul und
- zumindest eine erfindungsgemäße Anschlußdose,
wobei das Solarmodul zumindest zwei elektrische Leiter umfaßt, welche jeweils mit einer zugeordneten elektrischen Kontaktvorrichtung der Anschlußdose verbunden sind.

In anderen Worten kann das Solarpanel umfassen: ein Solarmodul mit einem im wesentlichen plattenförmigen Körper mit zumindest einer spannungserzeugenden Solarzellen, zumindest zwei mit der zumindest einen Solarzelle verbundenen Leiterbänder, die an einer Oberfläche des Solarmoduls aus diesen herausgeführt sind und zumindest eine erfindungsgemäße Anschlußdose. Es versteht sich, daß das Solarmodul auch 2, 3, 4, 5, 6, 7, 8, 9, 10, usw. Solarzellen bzw. Solarzellengruppen aufweisen kann und entsprechend 3, 4, 5, 6, 7, 8, 9, 10, 11 usw. elektrische Leiter umfaßt.

### Verwendung gemäß einem Aspekt

Ein weiterer Aspekt der vorliegenden Erfindung betrifft die Verwendung einer Anschlußdose mit den oben beschriebenen Merkmalen, zur Anordnung an einem Solarmodul als Eingangs- oder Ausgangsanschlußdose. Dabei wird die Anschlußdose an einer Anschlußseite des Solarmoduls angeordnet. Insbesondere kann danach die Anschlußdose mit dem Solarmodul elektrisch verbunden werden. Weiterhin kann die Anschlußdose verwendet werden, um das Solarmodul mit weiteren Solarmodulen oder elektrischen Verbrauchern zu verbinden.

### Figurenbeschreibung

Nachfolgend werden bevorzugte Ausführungsformen der vorliegenden Erfindung anhand der beigefügten Zeichnungen beispielhaft erläutert. Es zeigen:
- Figur 1:: eine perspektivische Ansicht einer Ausführungsform einer Anschlußdose;
- Figur 2:: eine perspektivische Ansicht einer weiteren Ausführungsform der Anschlußdose;
- Figur 3:: eine schematische Ansicht einer weiteren Ausführungsform der Anschlußdose; und
- Figur 4:: ein elektrisches Schaltbild der in den Figuren 1 bis 3 gezeigten Ausführungsformen;
- Figur 5:: eine perspektivische Ansicht einer Ausführungsform einer Anschlußdose;
- Figur 6:: ein elektrisches Schaltbild der in Figur 5 gezeigten Ausführungsform.

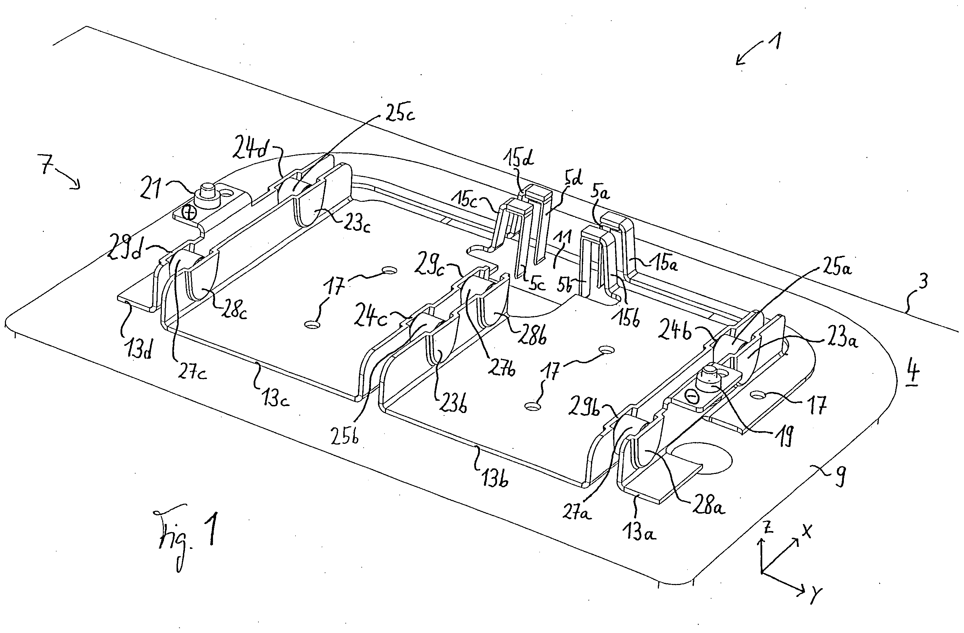

**Figur 1** zeigt eine perspektivische Ansicht einer Ausführungsform eines Solarpaneels 1 mit einem plattenförmigen Solarmodul 3, wobei auf einer Bestrahlungsseite des Solarmoduls 3 zumindest eine spannungserzeugende Solarzelle angeordnet ist, deren elektrische Leitungen 5a-5d in Form von Leiterbändern, welche auf einer Anschlußseite 4, welche der Bestrahlungsseite gegenüberliegend bzw. entgegengesetzt ist, aus dem Solarmodul 3 herausgeführt werden. Es ist jedoch auch möglich, die elektrischen Leitungen auf der Bestrahlungsseite herauszuführen.

Eine Anschlußdose 7 ist an bzw. auf der Anschlußseite des Solarmoduls 3 an bzw. auf diesem angeordnet. Die Anschlußseite 4 des Solarmoduls 3 erstreckt sich im wesentlichen entlang einer Richtung X und einer Richtung Y. Eine dritte Richtung Z steht auf den Richtungen X und Y senkrecht, d.h. senkrecht auf der Anschlußseite 4 des Solarmoduls 3, so daß die drei Richtungen X, Y, und Z ein orthogonales Koordinatensystem bilden. Die Anschlußdose 7 weist ein Gehäuse 9 auf, welches einen Öffnungsbereich 11 und einen Deckel (nicht gezeigt) zum Verschließen der Anschlußdose 7 umfaßt. Das Gehäuse 9 kann bevorzugt mittels eines Klebemittels an dem Solarmodul 3 befestigt sein.

Vorzugsweise weist diese Ausführungsform vier elektrisch leitfähige Kontaktvorrichtungen 13a-13d auf. Daher kann jede der vier elektrischen Leitungen bzw. Leiter 5a-5d des Solarmoduls 3 mit einem zugeordneten Leiterkontakt 15a-15d der zugeordneten Kontaktvorrichtung 13a-13d kontaktiert werden. Dazu sind die elektrischen Leitungen 5a-5d des Solarmodul 3 vorzugsweise durch einen gemeinsamen Öffnungsbereich 11 in das Gehäuse 9 geführt.

Zwei Kontaktvorrichtungen, beispielsweise die beiden äußersten Kontaktvorrichtungen 13a, 13d, können jeweils einen Anschlußpol 19, 21 umfassen. Die Anschlußpole 19, 21 können ein an die Anschlußdose 7 angeschlossenes Solarmodul 3 mit einem elektrischen Verbraucher (nicht gezeigt) innerhalb oder außerhalb der Anschlußdose 7 elektrisch verbinden. Da das Solarmodul 3 eine Gleichspannung erzeugt, kann einer der Anschlußpole 19 mit "-" bzw. als Anschlußminuspol 19 oder kurz Minuspol 19 und der andere Anschlußpol 21 mit "+" bzw. als Anschlußpluspol 21 oder kurz als Pluspol 21 bezeichnet werden. Im Betrieb fließt innerhalb der Anschlußdose 7 und des Solarmoduls 3, d.h. innerhalb der Stromquelle, der Strom I entlang der technischen Stromrichtung vom Minuspol 19 zum Pluspol 21.

Die erste Kontaktvorrichtung 13a kann beispielsweise den Anschlußminuspol 19 aufweisen. Weiter kann die erste Kontaktvorrichtung 13a einen anschlußpluspolseitigen Kurzschlußbereich 23a sowie einen anschlußpluspolseitigen Überspannungskurzschlußbereich 28a aufweisen.

Die benachbarte, zweite Kontaktvorrichtung 13b kann einen anschlußminuspolseitigen Kurzschlußbereich 24b aufweisen, welcher gegenüberliegend zu dem anschlußpluspolseitigen Kurzschlußbereich 23a der ersten Kontaktvorrichtung 13a angeordnet ist. Weiter kann die zweite Kontaktvorrichtung 13b einen anschlußminuspolseitigen Überspannungskurzschlußbereich 29b aufweisen, welcher gegenüberliegend zu dem korrespondierenden anschlußpluspolseitigen Überspannungskurzschlußbereich 28a der ersten Kontaktvorrichtung 13a angeordnet ist. Die Kurzschlußbereiche 23a, 24b sowie die Überspannungskurzschlußbereiche 28a, 29b können jeweils zumindest bereichsweise eben bzw. flach ausgebildet sein. Der anschlußpluspolseitige Kurzschlußbereich 23a kann somit im wesentlichen parallel zu dem zugeordneten anschlußminuspolseitigen Kurzschlußbereich 24b angeordnet sein. Ebenso kann der anschlußpluspolseitige Überspannungskurzschlußbereich 28a im wesentlichen parallel zu dem zugeordneten anschlußminuspolseitigen Überspannungskurzschlußbereich 29b angeordnet sein.

Analog kann die zweite Kontaktvorrichtung 13b einen anschlußpluspolseitigen Kurzschlußbereich 23b sowie einen anschlußpluspolseitigen Überspannungskurzschlußbereich 28b aufweisen, welche ebenfalls im wesentlichen parallel und gegenüberliegend zu dem korrespondierenden Kurzschlußbereich 24c bzw. zu dem korrespondierenden Überspannungskurzschlußbereich 29c der benachbarten, dritten Kontaktvorrichtung 13c angeordnet ist.

Dabei kann die dritte und jeder weitere Kontaktvorrichtung 13c einen anschlußpluspolseitigen Kurzschlußbereich 23c sowie einen anschlußpluspolseitigen Überspannungskurzschlußbereich 28c aufweisen, welche ebenfalls im wesentlichen parallel und gegenüberliegend zu dem korrespondierenden Kurzschlußbereich 24d bzw. zu dem korrespondierenden Überspannungskurzschlußbereich 29d der benachbarten, vierten oder weiteren Kontaktvorrichtung 13d angeordnet ist.

Die in der Figur 1 gezeigte bevorzugte Ausführungsform umfaßt lediglich vier Kontaktvorrichtungen, wobei die vierte und letzte Kontaktvorrichtung 13d den Anschlußpluspol 21 aufweisen kann.

Wie in Figur 1 gezeigt können sowohl die Kurzschlußbereiche 23a-23c und 24b-24d als auch die Überspannungskurzschlußbereiche 28a-28c und 29b-29d in einer Vertiefung bzw. in einem Rücksprung der zugeordneten Kontaktvorrichtung 13a-13d angeordnet sein. Bevorzugt können die Kurzschlußbereiche 23a-23c, 24b-24d und die Überspannungskurzschlußbereiche 28a-28c, 29b-29d zumindest bereichsweise, insbesondere vollständig, von einer Wandung umfangen bzw. umringt sein, welche im wesentlichen senkrecht zu dem jeweiligen umfangenen ebenen Bereich des Kurzschlußbereichs 23a-23c, 24b-24d bzw. Überspannungskurzschlußbereichs 28a-28c, 29b-29d orientiert ist. Bevorzugt sind die Wandungen und die zugehörigen Kurzschlußbereiche 23a-23c, 24b-24d bzw. Überspannungskurzschlußbereiche 28a-28c, 29b-29d ausgelegt, um ein elektrisches Bauteil aufzunehmen. Das Aufnehmen kann ein Festklemmen beinhalten, insbesondere wenn das aufgenommene elektrische Bauteil und die aufnehmende Wandung zueinander formkongruent sind.

Die Kontaktvorrichtungen 13a-13d können vorteilhafterweise einfach ausgebildet sein. Beispielsweise können die Kontaktvorrichtungen 13a-13d aus einem gestanzten, vorzugsweise flachen Metallblech bzw. Blechstanzteil gebildet sein. Hierbei ist es insbesondere möglich, daß jede der Kontaktvorrichtungen 13a-13d aus einem einstückigen, monolithischen Blechteil besteht. Die Kurzschlußbereiche, die Überspannungskurzschlußbereiche und die Leiterkontakte können beispielsweise durch Stanzen, Pressformen, Sicken und/oder Biegen hergestellt sein. In diesem Fall sind die Kontaktvorrichtungen 13a-13d besonders einfach und kostengünstig herzustellen.

Wie in Figur 1 gezeigt, können die Kontaktvorrichtungen 13a-13d sich bereichsweise parallel zu der Anschlußseite 4 des Solarmoduls 3 und in diesem Bereich eben ausgebildet sein. Bevorzugt ist jede Kontaktvorrichtung 13a-13d derart ausgebildet, insbesondere gebogen, daß sich die Kurzschlußbereiche 23a-23c, 24b-24d und/oder die Überspannungskurzschlußbereiche 28a-28c, 29b-29d im wesentlichen parallel zu den Richtungen X und Z oder zu den Richtungen Y und Z erstrecken.

Die Kontaktvorrichtungen 13a-13d können mittels einer Befestigungseinrichtung 17 mit dem Gehäuse 9 verbunden sein. Beispielsweise kann die Befestigungseinrichtung 17 als Bohrung 17 ausgebildet sein, wobei jede der Kontaktvorrichtungen 13a-13d mittels zumindest einer durch die Bohrung 17 hindurch dringende Schraube (nicht gezeigt) an dem Gehäuse 9 lösbar befestigt sein kann. Alternativ kann das Gehäuse aus einem thermoplastischen Kunststoff ausgebildet sein, welcher beim Ausbilden des Gehäuses 9 zumindest teilweise durch die Bohrung 17 dringt, um jede der Kontaktvorrichtungen 13a-13d zu hintergreifen und an dem aushärtenden Gehäuse 9 unlösbar zu befestigen.

Weiter können die Kontaktvorrichtungen 13a-13d derart voreinander beabstandet an dem Gehäuse 9 angeordnet sein, daß zwischen den einzelnen Kontaktvorrichtungen 13a-13d ein Spalt ausgebildet ist. Die Breite des Spaltes beträgt vorzugsweise etwa 1 mm bis 15 mm, insbesondere etwa 1 mm bis 9 mm. Weiter bevorzugt sind zwei benachbarte Kontaktvorrichtung, wie beispielhaft herausgegriffen die Kontaktvorrichtungen 13b, 13c, derart angeordnet, daß der anschlußminuspolseitige Kurzschlußbereich 24c gegenüberliegend zu dem anschlußpluspolseitigen Kurzschlußbereich 23b angeordnet ist. Vorzugsweise sind der anschlußminuspolseitige Kurzschlußbereich 24c und der anschlußpluspolseitigen Kurzschlußbereich 23b derart voneinander beabstandet, daß eine Bypass-Diode 25b zwischen diesen beiden gegenüberliegenden Kurzschlußbereichen angeordnet bzw. eingeklemmt werden kann.

Dabei können die beiden Kurzschlußbereiche 23b, 24c in einer Vertiefung bzw. einer Eindruckstelle angeordnet sein, so daß die beiden Kurzschlußbereiche zumindest bereichsweise von einer Wandung umfangen bzw. umringt sein können. Insbesondere erstrecken sich die beiden Kurzschlußbereiche 23b, 24c im wesentlichen entlang der Richtungen X und Z, wobei die Vertiefung entlang der Richtung Y ausgebildet ist. Vorzugsweise kann die Wandung in Richtung Z eine Öffnung aufweisen, so daß die Bypass-Diode 25b entgegen der Richtung Z in der Spalt zwischen den Kontaktvorrichtungen 13b und 13c bzw. zwischen den beiden Kurzschlußbereichen 23b, 24c angeordnet werden kann, wobei nach dem Anordnen eine Verlagerung der Bypass-Diode 25b senkrecht zur Einführrichtung, also zur Richtung Z, gehemmt ist. Vorteilhafterweise wird die Bypass-Diode 25b zwischen den Kurzschlußbereichen 23b, 24c gehalten und kann dort beispielsweise durch Verlöten befestigt werden. Die vorangehenden Ausführungen gelten analog für die weiteren gezeigten gegenüberliegenden Kurzschlußbereiche 23a, 24b und 23c, 24d.

Weiter bevorzugt sind die zwei beispielhaft herausgegriffenen Kontaktvorrichtungen 13b, 13c, derart angeordnet, daß der anschlußminuspolseitige Überspannungskurzschlußbereich 29c gegenüberliegend zu dem anschlußpluspolseitigen Überspannungskurzschlußbereich 28b angeordnet ist. Der anschlußminuspolseitige Überspannungskurzschlußbereich 29c und der anschlußpluspolseitigen Überspannungskurzschlußbereich 28b können derart voneinander beabstandet, daß ein Überspannungsschutzelement 27b zwischen diesen beiden gegenüberliegenden Überspannungskurzschlußbereichen 28b, 29c angeordnet bzw. eingeklemmt werden kann.

Analog zu den Kurzschlußbereichen 23b, 24c können die Überspannungskurzschlußbereiche 28b, 29c in einer Vertiefung bzw. einer Eindruckstelle angeordnet sein, so daß die beiden Überspannungskurzschlußbereiche 28b, 29c zumindest bereichsweise von einer Wandung umfangen bzw. umringt sein können. Insbesondere erstrecken sich die beiden Überspannungskurzschlußbereiche 28b, 29c im wesentlichen entlang der Richtungen X und Z, wobei die Vertiefung entlang der Richtung Y ausgebildet ist. Vorzugsweise kann die Wandung in Richtung Z eine Öffnung aufweisen, so daß das Überspannungsschutzelement 27b entgegen der Richtung Z in der Spalt zwischen den Kontaktvorrichtungen 13b und 13c bzw. zwischen den beiden Überspannungskurzschlußbereichen 28b, 29c angeordnet werden kann, wobei nach dem Anordnen eine Verlagerung der Bypass-Diode 25b senkrecht zur Einführrichtung, also zur Richtung Z, gehemmt ist. Vorteilhafterweise wird das Überspannungsschutzelement 27b zwischen den Überspannungskurzschlußbereichen 28b, 29c gehalten und kann dort beispielsweise durch Verlöten befestigt werden. Die vorangehenden Ausführungen gelten analog für die weiteren gezeigten gegenüberliegenden Überspannungskurzschlußbereichen 28a, 29b und 28c, 29d.Wie in Figur 1 gezeigt sind benachbarte Kontaktvorrichtungen 13a-13d jeweils durch Bypass-Dioden 25a-25c elektrisch miteinander verbunden. Um die Bypass-Dioden 25a-25c vor Spannungsspitzen zu schützen, ist jeder einzelnen Bypass-Diode 25a-25c ein Überspannungsschutzelement 27a-27c parallel geschaltet. Die Anzahl der Überspannungsschutzelemente 27a-27c ist demnach gleich der Anzahl der Bypass-Dioden 25a-25c.

Vorzugsweise können die Bypass-Dioden 25a-25c und die Überspannungsschutzelemente 27a-27c in ihrer relativen Position bezüglich der Richtung X alternierend angeordnet sein. Wie in Figur 1 gezeigt kann die erste Bypass-Diode 25a entlang der Richtung X von dem ersten Überspannungsschutzelement 27a beabstandet angeordnet sein. Mit anderen Worten befindet sich die erste Bypass-Diode 25a ausgehend von dem ersten Überspannungsschutzelement 27a in Richtung X. Dagegen kann die zweite Bypass-Diode 25b entgegen der Richtung X von dem zweiten Überspannungsschutzelement 27b beabstandet angeordnet sein. Das heißt, daß sich das zweite Überspannungsschutzelement 27b ausgehend von der zweiten Bypass-Diode 25b in Richtung X befindet. Die dritte Bypass-Diode 25c kann sich relativ zu dem dritten Überspannungsschutzelement 27c wiederum in Richtung X befinden.

Vorteilhafterweise sind die paarweisen Abstände der einzelnen Bypass-Dioden 25a-25c zueinander und auch die paarweisen Abstände der einzelnen Überspannungsschutzelemente 27a-27c zueinander gegenüber einer nicht alternierenden Anordnung vergrößert, so daß sich vorteilhafterweise die in den Bypass-Dioden 25a-25c und Überspannungsschutzelementen 27a-27c erzeugte thermische Energie über einen größeren Bereich der Leiterplatten der Kontaktvorrichtungen 13a-13d verteilt. Dadurch wird vorteilhafterweise die Abgabe der thermischen Energie von den Kontaktvorrichtungen 13a-13d an die Umgebung aufgrund der vergrößerten Austauschfläche begünstigt.

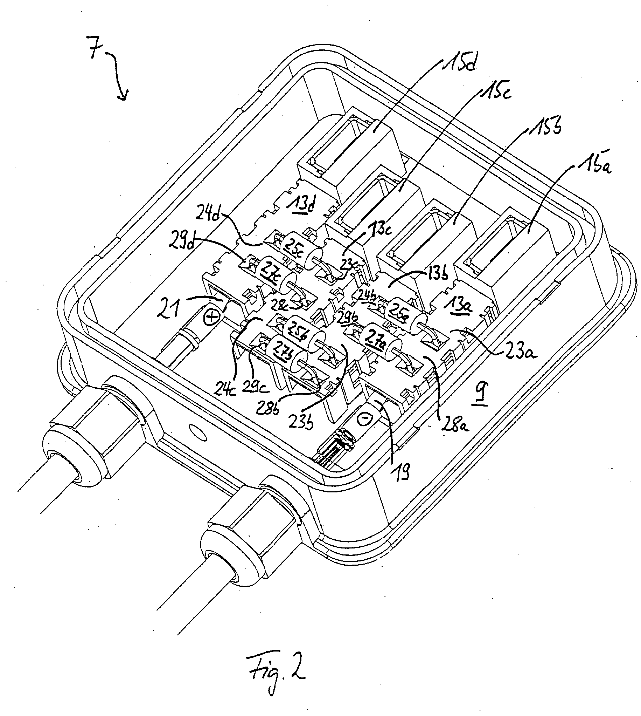

Figur 2 zeigt eine perspektivische Ansicht einer weiteren Ausführungsform einer Anschlußdose 7. Die Anschlußdose 7 weist ebenfalls ein mittels eines Deckels verschließbares Gehäuse 9 auf, welches einen Öffnungsbereich (nicht gezeigt) umfaßt. Das Gehäuse 9 kann mittels eines Klebemittels an einem Solarmodul befestigt sein.

Die gezeigte Ausführungsform weist bevorzugt vier elektrisch leitfähige Kontaktvorrichtungen 13a-13d auf. Daher können vier elektrische Leitungen bzw. Leiter des Solarmoduls mit einem zugeordneten Leiterkontakt 15a-15d der zugeordneten Kontaktvorrichtung 13a-13d kontaktiert werden.

Entsprechend zu der in Figur 1 gezeigten Ausführungsform umfaßt eine Kontaktvorrichtung 13a einen Anschlußminuspol 19 und eine Kontaktvorrichtung 13d einen Anschlußpluspol 21.

Die Kontaktvorrichtungen 13a-13d weisen jeweils einen anschlußpluspolseitigen Kurzschlußbereich 23a-23c und/oder einen einen anschlußminuspolseitigen Kurzschlußbereich 24b-24d auf, die ausgelegt sind, um eine Kontaktvorrichtung 13a-13d mit einer oder mehreren weiteren Kontaktvorrichtungen 13a-13d elektrisch zu verbinden. Die Kurzschlußbereiche 23a-23c, 24b-24d zweier benachbarter Kontaktvorrichtungen 13a-13d sind jeweils durch Bypass-Dioden 25a-25c elektrisch miteinander verbunden.

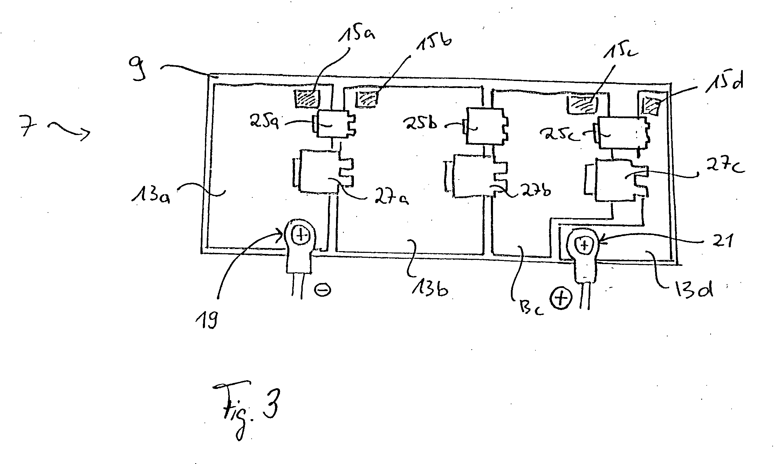

Die Kontaktvorrichtungen 13a-13d sind zwar als komplex geformtes Bauteil dargestellt. Die Kontaktvorrichtungen 13a-13d können jedoch einfacher ausgebildet sein, wie z.B. in den Figuren 1 und 3 gezeigt. Insbesondere können die Kontaktvorrichtungen 13a-13d aus einem gestanzten, vorzugsweise flachen Metallblech gebildet sein. Hierbei ist es insbesondere möglich, daß jede Kontaktvorrichtung der Kontaktvorrichtungen 13a-13d aus einem einstückigen, monolithischen Blechteil besteht. Somit kann das Blechteil den Anschlußbereich, den Kurzschlußbereich und den Leiterkontakt umfassen. In diesem Fall ist die Kontaktvorrichtung besonders einfach und kostengünstig herzustellen.

Wie in Figur 1 sind benachbarte Kontaktvorrichtungen 13a-13d jeweils durch Bypass-Dioden 25a-25c elektrisch miteinander verbunden, wobei zu jeder einzelnen Bypass-Diode 25a-25c ein Überspannungsschutzelement 27a-27c parallel geschaltet ist. Die weiteren Bauteile der in Figur 2 gezeigten Ausführungsform, die mit den in Figur 1 gezeigten Bauteile korrespondieren sind in Figur 2 mit gleichen Bezugszeichen wie in Figur 1 bezeichnet.

Figur 3 zeigt eine schematische Ansicht einer weiteren Ausführungsform einer Anschlußdose 7. Die in Figur 3 gezeigte Anschlußdose 7 ist ähnlich wie die in den Figuren 1 und 2 gezeigten Anschlußdosen 7 aufgebaut. Die Anschlußdose 7 umfaßt ein Gehäuse 9 mit vier darin angeordneten Kontaktvorrichtungen 13a-13d, die jeweils als flaches Blechstanzelement ausgebildet sind. Die Kontaktvorrichtungen 13a-13d umfassen jeweils Leiterkontakte, Kurzschlußbereiche und Überspannungskurzschlußbereiche. Da die Kontaktvorrichtungen 13a-13d vorzugsweise einstückig monolithisch sind, sind die Leiterkontakte und die Kurzschlußbereiche integrale Bestandteile der Kontaktvorrichtungen 13-13d. Daher sind die Leiterkontakte und die Kurzschlußbereiche nicht gesondert dargestellt. Ferner sind in Figur 3 Bypass-Dioden 25a-25c und Überspannungsschutzelemente 27a-27c gezeigt. Ein Anschlußminuspol 19 und ein Anschlußpluspol 21 sind mit den entsprechenden Kontaktvorrichtungen 13a, 13d verbunden.

Das in Figur 3 gezeigt Gehäuse 9 kann aus einem Gehäusematerial spritzgegossen sein, so daß insbesondere die Kontaktvorrichtungen 13a-13d, die Bypass-Dioden 25a-25c und die Überspannungsschutzelemente 27a-27c in das Gehäusematerial eingebettet sind. In diesem Fall können der Anschlußminuspol 19 und der Anschlußpluspol 21 freigelegt sein, um die entsprechenden elektrischen Kontakte zu ermöglichen.

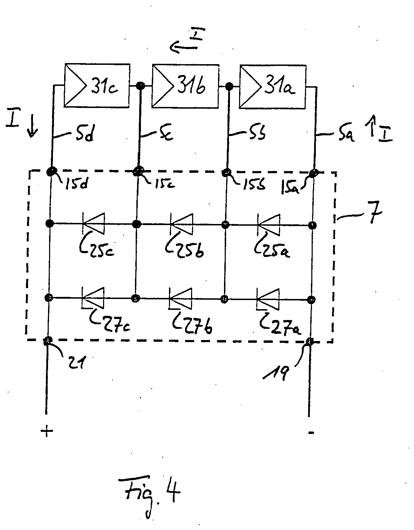

Figur 4 zeigt das elektrische Schaltbild der in den Figuren 1 bis 3 gezeigten Ausführungsformen der Anschlußdose 7. Das Solarmodul 3 weist drei Solarzellengruppen 31a-31c auf, welche durch die elektrischen Leiter 5a-5d mit den elektrischen Leiterkontakten 15a-15d der Kontaktvorrichtungen 13a-13d verbunden sind. Zwei benachbarte Kontaktvorrichtungen 13a-13d sind somit über eine der Solarzellengruppen 31a-31c des Solarmoduls 3 miteinander elektrisch verbunden. Die Sperrichtung der Bypass-Dioden 25a-25c sind jeweils antiparallel zu der Stromrichtung des Stroms I geschaltet, der über die Solarzellengruppen 31a-31c des Solarmoduls 3 zwischen den benachbarten Kontaktvorrichtungen 13a-13d fließt.

Sollte beispielsweise aufgrund einer Abschattung die elektrische Verbindung, welche über die Solarzellengruppe 31b verläuft, einen Widerstand aufweisen, so daß der Spannungsabfall einen vorbestimmbaren Schwellwert überschreitet, so überschreitet auch der Spannungsabfall zwischen den Anschlußbereichen der entsprechenden benachbarten Kontaktvorrichtungen 13a, 13c einen davon abhängigen Schwellwert. Bei Überschreitung des vorbestimmbaren Schwellwerts, verliert die entsprechende Bypass-Diode 25b ihre Sperrwirkung und stellt einen Kurzschluß zwischen den benachbarten Kontaktvorrichtungen 13a, 13c her. Vorzugsweise fließt der Gesamtstrom des Solarpaneels dadurch nicht durch die überbrückte Solarzellengruppe 31b, wodurch dort weder elektrische Leistungsverluste durch den erhöhten Widerstand der Solarzellengruppe noch eine Beschädigung der Solarzellengruppe, beispielsweise durch Erwärmung aufgrund der elektrischen Verlustleistung, auftreten. Vielmehr fließt der elektrische Strom durch die Bypass-Diode 25b.

Die Bypass-Dioden 25a-25c sind in Reihe geschaltet und stellen eine elektrische Verbindung zwischen dem Anschlußminuspol 19 und dem Anschlußpluspol 21 her. Um die Bypass-Dioden 25a-25c vor Überspannungen zu schützen, die beispielsweise aufgrund von Induktivitäten auftreten, wenn der Anschlußminuspol 19 und/oder der Anschlußpluspol 21 von einem Verbraucher getrennt oder daran angeschlossen werden, ist zu jeder der Bypass-Dioden 25a-25c ein Überspannungsschutzelement, bevorzugt eine Zener-Diode, eine Supressor-Diode oder ein Transistor Voltage Suppressor, derart parallel geschaltet ist, daß das Überspannungsschützelement 27a-27c die zugeordnete Bypass-Diode 25a-25c überbrückt, wenn eine Überspannung an der betreffenden Bypass-Diode anliegt. Vorteilhafterweise kann jede einzelne der Bypass-Dioden 25a-25c vor Überspannungen geschützt werden, insbesondere, wenn die Überspannung lediglich an einer einzelnen Bypass-Diode anliegt und nicht an allen Bypass-Dioden 25a-25c gleichzeitig, wie dies z.B. bei Induktionsströmen aufgrund eines Blitzschlages der Fall sein kann.

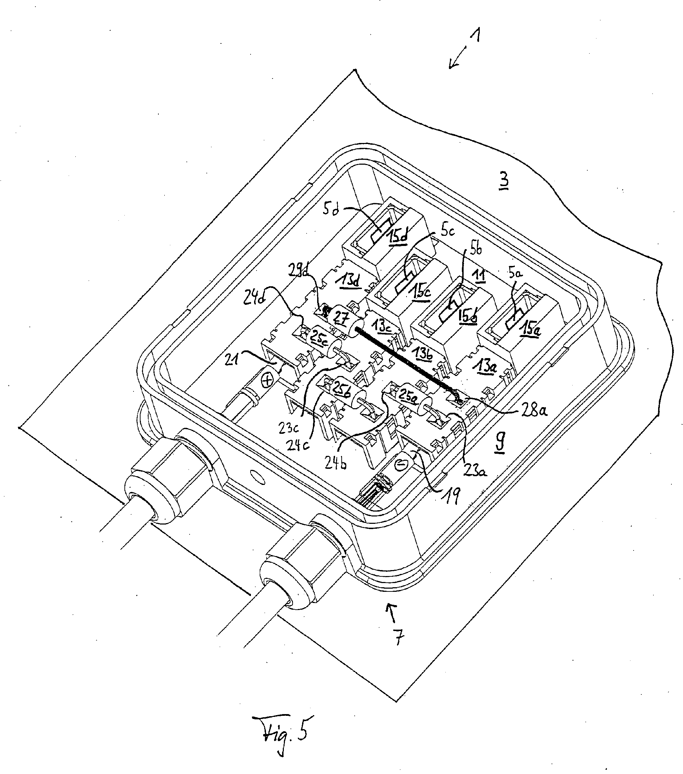

**Figur 5** zeigt eine perspektivische Ansicht einer Ausführungsform eines Solarpaneels 1 mit einem plattenförmigen Solarmodul 3, wobei auf einer Bestrahlungsseite des Solarmoduls 3 zumindest eine spannungserzeugende Solarzelle angeordnet ist, deren elektrische Leitungen 5a-5d in Form von Leiterbändern, welche auf der Anschlußseite 4, welche der Bestrahlungsseite gegenüberliegend bzw. entgegengesetzt ist, aus dem Solarmodul 3 herausgeführt werden. Es ist jedoch auch möglich, die elektrischen Leitungen auf der Bestrahlungsseite heraus zu führen.

Eine Anschlußdose 7 ist an bzw. auf der Anschlußseite des Solarmoduls 3 an bzw. auf diesem angeordnet. Die Anschlußdose 7 weist ein Gehäuse 9 auf, welches einen Öffnungsbereich 11 und einen Deckel (nicht gezeigt) zum Verschließen der Anschlußdose 7 umfaßt. Das Gehäuse 9 kann bevorzugt mittels eines Klebemittels an dem Solarmodul 3 befestigt sein.

Vorzugsweise weist in diese Ausführungsform vier elektrisch leitfähige Kontaktvorrichtungen 13a-13d auf. Daher kann jede der vier elektrischen Leitungen bzw. Leiter 5a-5d des Solarmoduls 3 mit einem zugeordneten Leiterkontakt 15a-15d der zugeordneten Kontaktvorrichtung 13a-13d kontaktiert werden. Dazu sind die elektrischen Leitungen 5a-5d des Solarmodul 3 vorzugsweise durch einen gemeinsamen Öffnungsbereich 11 in das Gehäuse 9 geführt.

Eine Kontaktvorrichtung 13a umfaßt einen Anschlußminuspol 19, während eine andere Kontaktvorrichtung 13d einen Anschlußpluspol 21 aufweist. Der Anschlußminuspol 19 bzw. der Anschlußpluspol 21 könnten jeweils als Verbinder ausgebildet sein oder als Kontakte eines Verbinders.

Die Kontaktvorrichtungen 13a-13d weisen jeweils einen anschlußpluspolseitigen Kurzschlußbereich 23a-23c und/oder einen einen anschlußminuspolseitigen Kurzschlußbereich 24b-24d auf, die ausgelegt sind, um eine Kontaktvorrichtung 13a-13d mit einer oder mehreren weiteren Kontaktvorrichtungen 13a-13d elektrisch zu verbinden. Die Kurzschlußbereiche 23a-23c, 24b-24d zweier benachbarter Kontaktvorrichtungen 13a-13d sind jeweils durch Bypass-Dioden 25a-25c elektrisch miteinander verbunden.

Die Kontaktvorrichtungen 13a-13d sind zwar als komplexes Bauteil dargestellt. Die Kontaktvorrichtungen 13a-13d können jedoch einfacher ausgebildet sein, wie z.B. in Figur 1 oder in Figur 3 gezeigt. Insbesondere können die Kontaktvorrichtungen 13a-13d aus einem gestanzten, vorzugsweise flachen Metallblech gebildet sein. Hierbei ist es insbesondere möglich, daß jede Kontaktvorrichtung der Kontaktvorrichtungen 13a-13d aus einem einstückigen, monolithischen Blechteil besteht. Somit kann das Blechteil den Anschlußbereich, den Kurzschlußbereich und den Leiterkontakt umfassen. In diesem Fall ist die Kontaktvorrichtung besonders einfach und kostengünstig herzustellen.

Um die Bypass-Dioden 25a-25c vor Spannungsspitzen zu schützen, ist parallel zu den in Reihe geschalteten Bypass-Dioden 25a-25c ein Überspannungsschutzelement 27 geschaltet, wobei die Kontaktvorrichtungen 13a, 13d, an denen der Anschlußminuspol 19 und der Anschlußpluspol 21 angeschlossen sind, mittels des Überspannungsschutzelemente 27, insbesondere unmittelbar, elektrisch verbunden sind. Dazu weist die Kontaktvorrichtung 13a einen anschlußpluspolseitigen Überspannungskurzschlußbereich 28a auf und die Kontaktvorrichtung 13d weist einen anschlußminuspolseitigen Überspannungskurzschlußbereich 29d auf, wobei der anschlußpluspolseitigen Überspannungskurzschlußbereich 28a und der einen anschlußminuspolseitigen Überspannungskurzschlußbereich 29d mittels des Überspannungsschutzelemente 27 elektrisch verbunden sind.

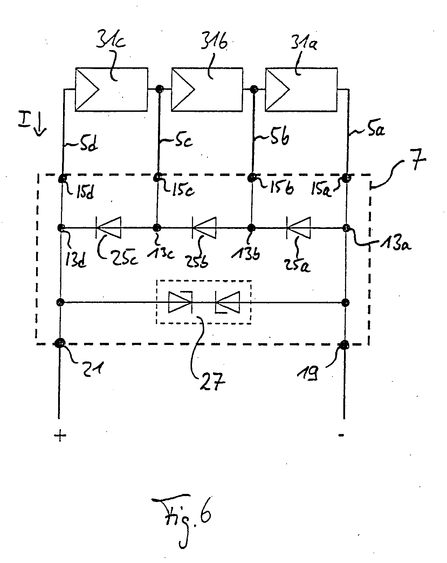

**Figur 6** zeigt das elektrische Schaltbild der in Figur 5 gezeigten Ausführungsform der Anschlußdose 7, welches im wesentlich dem in Figur 4 gezeigten Schaltbild entspricht. Wieder sind die Bypass-Dioden 25a-25c in Reihe geschaltet und stellen eine elektrische Verbindung zwischen dem Anschlußminuspole 19 und dem Anschlußpluspol 21 her. Um die Bypass-Dioden 25a-25c vor Überspannungen zu schützen, die beispielsweise aufgrund von Induktivitäten auftreten, wenn die Anschlußpole 19 und 21 von einem Verbraucher getrennt oder daran angeschlossen werden, kann ein Überspannungsschutzelement 27, bevorzugt eine sogenannte bipolare Supressor-Diode, derart parallel zu den Bypass-Dioden geschaltet sein, daß der Anschlußminuspol 19 und der Anschlußpluspol 21 durch das Überspannungsschutzelement 27 miteinander elektrisch kontaktiert sind.

Für den Fall, daß zwischen dem Anschlußminuspol 19 und dem Anschlußpluspol 21 eine Spannungsspitze anliegt, typischerweise größer als 100 Volt, überbrückt das Überspannungsschutzelement 27 die in Reihe geschalteten Bypass-Dioden 25a-25c, so daß ein Kurzschluß zwischen dem Anschlußminuspol 19 und dem Anschlußpluspol 21 hergestellt wird. Der aufgrund der Spannungsspitze fließende elektrische Strom wird dadurch über das Überspannungsschutzelement 27 geleitet, so daß Bypass-Dioden 25a-25c geschützt sind. Vorzugsweise ist der ohmsche Widerstand über das Überspannungsschutzelement 27 geringer als über die in Reihe geschalteten Bypass-Dioden 25a-25c. Weiter bevorzugt ist die Ansprechzeit des Überspannungsschutzelement 27 kleiner als die Ansprechzeit der Bypass-Dioden 25a-25c.

Die in den beschriebenen Figuren gezeigten Ausführungsformen der Anschlußdose 7 weisen Kontaktvorrichtungen 13a-13d auf, welche vorzugsweise einstückig aus Metall hergestellt sind und weiter vorzugsweise einen Klemmbereich für die Bypass-Dioden 25a-25c und/oder das/die Überspannungsschutzelement(e) 27; 27a-27c umfassen. Bevorzugt sind die entsprechenden elektronischen Bauteile in einer Ausführung als SMD Bauteil auf der Leiterplatte angeordnet.

Die vorliegende Erfindung ist nicht auch die obigen, beispielhaft beschriebenen Ausführungsformen beschränkt. Vielmehr können einzelne Elemente und/oder Merkmale eines jeden beschriebenen Aspekts und/oder einer jeden beschriebenen Ausführungsform mit einzelnen Elementen und/oder Merkmalen der weiteren Aspekte und/oder weiteren Ausführungsformen in beliebiger Weise miteinander kombiniert werden und somit weitere Aspekte und/oder Ausführungsformen gebildet werden.

### Bezugszeichentiste

- 1: Solarpaneel
- 3: Solarmodul
- 4: Anschlußseite des Solarmoduls 3
- 5a-5d: elektrischer Leiter des Solarmodul 3
- 7: Anschlußdose
- 9: Gehäuse
- 11: Öffnungsbereich
- 13a-13d: Kontaktvorrichtung
- 15a-15d: Leiterkontakt
- 17: Befestigungselement
- 19: Anschlußminuspol
- 21: Anschlußpluspol
- 23a-23c: anschlußpluspolseitiger Kurzschlußbereich
- 24b-24d: anschlußminuspolseitiger Kurzschlußbereich
- 25a-25c: Bypass-Diode
- 27;27a-27c: Überspannungsschutzelement
- 28a-28c: anschlußpluspolseitigen Überspannungskurzschlußbereich
- 29b-29d: anschlußminuspolseitigen Überspannungskurzschlußbereich
- 31a-31d: Solarzellengruppe
- I: Stromrichtung
- X: Richtung
- Y: Richtung
- Z: Richtung

## Patentansprüche

1. Anschlußdose (7) für ein Solarmodul (3) umfassend:
- einen elektrischen Anschlußminuspol (19) und einen elektrischen Anschlußpluspol (21),
- zumindest zwei elektrische Kontaktvorrichtungen (13a, 13b, 13c, 13d),
-- wobei jede der zumindest zwei elektrischen Kontaktvorrichtungen (13a, 13b, 13c, 13d) mit einem zugeordneten elektrischen Leiter (5a, 5b, 5c, 5d) des Solarmoduls (3) kontaktierbar ist und
-- wobei zumindest zwei der zumindest zwei Kontaktvorrichtungen (13a, 13b, 13c, 13d) als Leiterplatte ausgebildet sind,
- zumindest eine Bypass-Diode (25a, 25b, 25c), wobei die zumindest eine Bypass-Diode (25a, 25b, 25c) zwei der Kontaktvorrichtungen (13a, 13b, 13c, 13d) elektrisch verbindet,
**dadurch gekennzeichnet, dass**
- die Anschlußdose zumindest ein Überspannungsschutzelement (27; 27a, 27b, 27c) umfasst,
wobei das zumindest eine Überspannungsschutzelement (27, 27a, 27b, 27c) parallel zu zumindest einer der zumindest einen Bypass-Diode (25a, 25b, 25c) geschaltet ist und
wobei die Ansprechzeit des zumindest einen Überspannungsschutzelementes (27, 27a, 27b, 27c) kleiner ist als die Ansprechzeit der Bypass-Dioden (25a, 25b, 25c), um die zumindest eine Bypass-Diode (25a, 25b, 25c) vor Überspannungen zu schützen.

2. Anschlußdose (7) nach Anspruch 1, wobei genau ein Überspannungsschutzelement (27) den Anschlußminuspol (19) mit dem Anschlußpluspol (21) elektrisch verbindet.

3. Anschlußdose (7) nach Anspruch 1, umfassend:
- N elektrische Kontaktvorrichtungen (13a, 13b, 13c, 13d), welche jeweils mit einem zugeordneten elektrischen Leiter (5a, 5b, 5c, 5d) des Solarmoduls (3) kontaktierbar sind,
- N-1 Bypass-Dioden (25a, 25b, 25c), und
- N-1 Überspannungsschutzelemente (27a, 27b, 27c),
wobei jeweils zwei der elektrischen Kontaktvorrichtungen (13a, 13b, 13c, 13d) durch eine Bypass-Diode (25a, 25b, 25c) und ein dazu parallel geschaltetes Überspannungsschutzelement (27a, 27b, 27c) elektrisch verbunden sind.

4. Anschlußdose (7) nach einem der vorigen Ansprüche,
- wobei jede der zumindest zwei Kontaktvorrichtungen (13b, 13c), die als Leiterplatte ausgebildet sind, einen zumindest bereichsweise eben ausgebildeten anschlußpluspolseitigen Kurzschlußbereich (23b, 23c) und/oder einen zumindest bereichsweise eben ausgebildeten anschlußminuspolseitigen Kurzschlußbereich (24b, 24c) und/oder
- wobei jede der zumindest zwei Kontaktvorrichtungen (13b, 13c)), die als Leiterplatte ausgebildet sind, einen zumindest bereichsweise eben ausgebildeten anschlußpluspolseitigen Überspannungskurzschlußbereich (28a, 28b, 28c) und/oder einen zumindest bereichsweise eben ausgebildeten anschlußminuspolseitigen Überspannungskurzschlußbereich (29b, 29c, 29d) aufweist.

5. Anschlußdose (7) nach Anspruch 4,
- wobei jeder der anschlußpluspolseitigen Kurzschlußbereiche (23a, 23b, 23c) parallel und gegenüberliegend zu einem zugeordneten anschlußminuspolseitigen Kurzschlußbereich (24b, 24c, 24d) der benachbarten Kontaktvorrichtung (13a, 13b, 13c, 13d) angeordnet ist und/oder
- wobei jeder der anschlußpluspolseitigen Überspannungskurzschlußbereiche (28a, 28b, 28c) parallel und gegenüberliegend zu einem zugeordneten anschlußminuspolseitigen Überspannungskurzschlußbereich (29b, 29c, 29d) der benachbarten Kontaktvorrichtung (13a, 13b, 13c, 13d) angeordnet ist.

6. Anschlußdose (7) nach einem der Ansprüche 3 bis 5,
wobei für alle geradzahligen n mit 1 < n ≤ N und N ≥ 3 gilt, daß eine (n-1)-te Bypass-Diode (25a), welche die (n-1)-te Kontaktvorrichtung (13a) mit der n-ten Kontaktvorrichtung (13b) elektrisch verbindet, entlang einer Richtung (X, Y) von einem (n-1)-ten Überspannungsschutzelement (27a), welches die (n-1)-te Kontaktvorrichtung (13a) mit der n-ten Kontaktvorrichtung (13b) elektrisch verbindet, beabstandet ist und
wobei für alle geradzahligen n mit 1 < n < N und N ≥ 3 gilt, daß eine n-te Bypass-Diode (25b), welche die (n+1)-te Kontaktvorrichtung (13c) mit der n-ten Kontaktvorrichtung (13b) elektrisch verbindet, entgegen der Richtung (X, Y) von einem n-ten Überspannungsschutzelement (27b), welches die (n+1)-te Kontaktvorrichtung (13c) mit der n-ten Kontaktvorrichtung (13b) elektrisch verbindet, beabstandet ist.

7. Anschlußdose (7) nach einem der vorigen Ansprüche, wobei zumindest zwei der elektrischen Kontaktvorrichtungen (13a, 13b, 13c) ausschließlich mittels zumindest einer Bypass-Diode (25a, 25b, 25c) und/oder zumindest eines Überspannungsschutzelementes (27a, 27b, 27c) mechanisch verbunden sind.

8. Anschlußdose (7) nach einem der vorigen Ansprüche, wobei das zumindest eine Überspannungsschutzelement (27a, 27b, 27c) eine Supressor-Diode, eine bipolare Supressor-Diode, eine Zener-Diode, eine Schottky-Diode, ein Varistor oder ein Transistor Voltage Supressor ist.

9. Anschlußdose (7) nach einem der vorigen Ansprüche, wobei zumindest einer der anschlußpluspolseitigen Kurzschlußbereiche (23a, 23b, 23c), der anschlußminuspolseitigen Kurzschlußbereiche (24b, 24c, 24d), der anschlußpluspolseitigen Überspannungskurzschlußbereiche (28a, 28b, 28c) und/oder der anschlußminuspolseitigen Überspannungskurzschlußbereiche (29b, 29c, 29d) ein Lötmitteldepot aufweist.

10. Solarpaneel (1) umfassend:
- zumindest ein im wesentlichen plattenförmiges Solarmodul (3) und
- zumindest eine Anschlußdose (7) gemäß einem der vorangegangenen Ansprüche,
wobei das Solarmodul (3) zumindest zwei elektrische Leiter (5a, 5b) umfaßt, welche jeweils mit einer zugeordneten elektrischen Kontaktvorrichtung (13a, 13b) der Anschlußdose (7) verbunden sind.

## Claims

1. A connection socket (7) for a solar module (3), comprising:
- an electrical connection minus pole (19) and an electrical connection plus pole (21),
- at least two electrical contact devices (13a, 13b, 13c, 13d),
-- wherein each of the at least two electrical contact devices (13a, 13b, 13c, 13d) can be contacted with an associated electrical conductor (5a, 5b, 5c, 5d) of the solar module (3), and
-- wherein at least two of the at least two contact devices (13a, 13b, 13c, 13d) are designed as printed circuit boards,
- at least one bypass diode (25a, 25b, 25c), wherein the at least one bypass diode (25a, 25b, 25c) electrically connects two of the contact devices (13a, 13b, 13c, 13d),
**characterized in that**
- the connection socket comprises at least one overvoltage protection element (27; 27a, 27b, 27c),
wherein the at least one overvoltage protection element (27, 27a, 27b, 27c) is parallel-connected to at least one of the at least one bypass diode (25a, 25b, 25c), and
wherein the response time of the at least one overvoltage protection element (27, 27a, 27b, 27c) is less than the response time of the bypass diodes (25a, 25b, 25c) in order to protect the at least one bypass diode (25a, 25b, 25c) from overvoltages.

2. The connection socket (7) according to claim 1, wherein precisely one overvoltage protection element (27) electrically connects the connection minus pole (19) to the connection plus pole (21).

3. The connection socket (7) according to claim 1, comprising:
- N electrical contact devices (13a, 13b, 13c, 13d) that can each be contacted with one associated electrical conductor (5a, 5b, 5c, 5d) of the solar module (3),
- N-1 bypass diodes (25a, 25b, 25c), and
- N-1 overvoltage protection elements (27a, 27b, 27c),
wherein in each case, two of the electrical contact devices (13a, 13b, 13c, 13d) are electrically connected by a bypass diode (25a, 25b, 25c) and an overvoltage protection element (27a, 27b, 27c) parallel-connected thereto.

4. The connection socket (7) according to one of the preceding claims,
- wherein each of the at least two contact devices (13b, 13c) that are designed as a printed circuit board have a connection plus pole side short-circuit region (23b, 23c) which is designed at least sectionally flat, and/or a connection minus pole side short-circuit region (24b, 24c) which is designed at least sectionally flat, and/or
- wherein each of the at least two contact devices (13b, 13c) that are designed as a printed circuit board have a connection plus pole side overvoltage short-circuit region (28a, 28b, 28c) which is designed at least sectionally flat, and/or a connection minus pole side overvoltage short-circuit region (29b, 29c, 29d) which is designed at least sectionally flat.

5. The connection socket (7) according to claim 4,
- wherein each of the connection plus pole side short-circuit regions (23a, 23b, 23c) are arranged parallel and opposite an associated connection minus pole side short-circuit region (24b, 24c, 24d) of the adjacent contact device (13a, 13b, 13c, 13d), and/or
- wherein each of the connection plus pole side overvoltage short-circuit regions (28a, 28b, 28c) are arranged parallel and opposite an associated connection minus pole side overvoltage short-circuit region (29b, 29c, 29d) of the adjacent contact device (13a, 13b, 13c, 13d).

6. The connection socket (7) according to one of claims 3 to 5,
wherein for all even number n with 1 < n ≤ N and N ≥ 3, an (n-1)-th bypass diode (25a) that electrically connects the (n-1)-th contact device (13a) to the n-th contact device (13b) is at a distance along a direction (X, Y) from an (n-1)-th overvoltage protection element (27a) that connects the (n-1)-th contact device (13a) to the n-th contact device (13b), and wherein for all even number n with 1 < n < N and N ≥ 3, an n-th bypass diode (25b) that electrically connects the (n+1)-th contact device (13c) to the n-th contact device (13b) is at a distance counter to the direction (X, Y) from an n-th overvoltage protection element (27b) that connects the (n+1)-th contact device (13c) to the n-th contact device (13b).

7. The connection socket (7) according to one of the preceding claims, wherein at least two of the electrical contact devices (13a, 13b, 13c) are mechanically connected exclusively by means of at least one bypass diode (25a, 25b, 25c) and/or at least one overvoltage protection element (27a, 27b, 27c).

8. The connection socket (7) according to one of the preceding claims, wherein the at least one overvoltage protection element (27a, 27b, 27c) is a suppressor diode, a bipolar suppressor diode, a Zener diode, a Schottky diode, a varistor or a transistor voltage suppressor.

9. The connection socket (7) according to one of the preceding claims, wherein at least one of the connection plus pole side short-circuit regions (23a, 23b, 23c), the connection minus pole side short-circuit regions (24b, 24c, 24d), the connection plus pole side overvoltage short-circuit regions (28a, 28b, 28c) and/or the connection minus pole side overvoltage short-circuit regions (29b, 29c, 29d) has a solder paste deposit.

10. A solar panel (1), comprising:
- at least one substantially panel-shaped solar module (3) and
- at least one connection socket (7) according to one of the preceding claims,
wherein the solar module (3) comprises at least two electrical conductors (5a, 5b) that are each connected to an associated electrical contact device (13a, 13b) of the connection socket (7).

## Revendications

1. Boîte de jonction (7) pour un module solaire (3) comportant :
- une borne négative de connexion électrique (19) et une borne positive de connexion électrique (21),
- au moins deux dispositifs de contact électrique (13a, 13b, 13c, 13d),
-- où chacun des au moins deux dispositifs de contact électriques (13a, 13b, 13c, 13d) est susceptible d'être mis en contact avec un conducteur électrique associé (5a, 5b, 5c, 5d) du module solaire (3) et
-- où au moins deux des aux moins deux dispositifs de contact (13a, 13b, 13c, 13d) sont conçus en tant que carte à circuit imprimé,
- au moins une diode bypass (25a, 25b, 25c), où ladite au moins une diode bypass (25a, 25b, 25c) relie électriquement deux des dispositifs de contact (13a, 13b, 13c, 13d),
**caractérisée en ce que**
- la boîte de jonction comporte au moins un élément de protection de surtensions (27; 27a, 27b, 27c),
où ledit au moins un élément de protection de surtensions (27, 27a, 27b, 27c) est branché en parallèle à au moins une d'au moins une diode bypass (25a, 25b, 25c), et
où le temps de réponse d'au moins un élément de protection de surtensions (27, 27a, 27b, 27c) est inférieur au temps de réponse des diodes bypass (25a, 25b, 25c) afin de protéger l'au moins une diode bypass (25a, 25b, 25c) contre les surtensions.

2. Boîte de jonction (7) selon la revendication 1, où exactement un élément de protection de surtensions (27) relie la borne négative de connexion (19) à la borne positive de connexion (21).

3. Boîte de jonction (7) selon la revendication 1, comportant :
- N dispositifs de contact électriques (13a, 13b, 13c, 13d), lesquels sont respectivement susceptibles d'entrer en contact avec un conducteur électrique associé (5a, 5b, 5c, 5d) du module solaire (3),
- N-1 diodes bypass (25a, 25b, 25c), et
- N-1 éléments de protection de surtensions (27a, 27b, 27c),
où respectivement deux des dispositifs de contact électriques (13a, 13b, 13c, 13d) sont reliés électriquement à l'aide d'une diode bypass (25a, 25b, 25c) et d'un élément de protection de surtensions (27a, 27b, 27c) y étant branché parallèlement.

4. Boîte de jonction (7) selon l'une quelconque des revendications précédentes,
- où chacun des au moins deux dispositifs de contact (13b, 13c), lesquels sont conçus en tant que carte à circuit imprimé, présente une région de court-circuit (23b, 23c), côté borne positive de connexion, conçue plane, au moins par endroits, et/ou une région de court-circuit (24b, 24c), côté borne négative de connexion, conçue plane, au moins par endroits et/ou
- où chacun des au moins deux dispositifs de contact (13b, 13c), lesquels sont conçus en tant que carte à circuit imprimé, présente une région de court-circuit de surtensions (28a, 28b, 28c), côté borne positive de connexion, conçue plane, au moins par endroits et/ou une région de court-circuit de surtensions (29b, 29c, 29d), côté borne négative de connexion, conçue plane, au moins par endroits.

5. Boîte de jonction (7) selon la revendication 4,
- où chacune des régions de court-circuit (23a, 23b, 23c), côté borne positive de connexion, est agencée parallèle et opposée à une région de court-circuit associée (24b, 24c, 24d), côté borne négative de connexion, du dispositif de contact adjacent (13a, 13b, 13c, 13d) et/ou
- où chacune des régions de court-circuit de surtensions (28a, 28b, 28c), côté borne positive de connexion, est agencée parallèle et opposée à une région de court-circuit de surtensions associée (29b, 29c, 29d), côté borne négative de connexion, du dispositif de contact adjacent (13a, 13b, 13c, 13d).

6. Boîte de jonction (7) selon une des revendications de 3 à 5,
où pour tous les n pairs avec 1 < n ≤ N et N ≥ 3, le critère suivant s'applique : une (n-1)ème diode bypass (25a), laquelle relie électriquement le (n-1)ème dispositif de contact (13a) au n-ième dispositif de contact (13b), est espacée, le long d'une direction (X, Y), d'un (n-1)ème élément de protection de surtensions (27a), lequel relie électriquement le (n-1)ème dispositif de contact (13a) au n-ième dispositif de contact (13b), et
où pour tous les n pairs avec 1 < n < N et N ≥ 3, le critère suivant s'applique : une n-ième diode bypass (25b), laquelle relie électriquement le (n+1)ème dispositif de contact (13c) au n-ième dispositif de contact (13b), est espacée, opposée à la direction (X, Y), d'un n-ième élément de protection de surtensions (27b), lequel relie électriquement le (n+1)ème dispositif de contact (13c) au n-ième dispositif de contact (13b).

7. Boîte de jonction (7) selon l'une quelconque des revendications précédentes, où au moins deux des dispositifs de contact électriques (13a, 13b, 13c) sont reliés mécaniquement exclusivement à l'aide d'au moins une diode bypass (25a, 25b, 25c) et/ou d'au moins un élément de protection de surtensions (27a, 27b, 27c).

8. Boîte de jonction (7) selon l'une quelconque des revendications précédentes, où ledit au moins un élément de protection de surtensions (27a, 27b, 27c) est une diode Suppressor, une diode Suppressor bipolaire, une diode Zener, une diode Schottky, une varistance ou un Transistor Voltage Suppressor.

9. Boîte de jonction (7) selon l'une quelconque des revendications précédentes, où au moins une des régions de court-circuit (23a, 23b, 23c), côté borne positive de connexion, des régions de court-circuit (24b, 24c, 24d), côté borne négative de connexion, des régions de court-circuit de surtensions (28a, 28b, 28c), côté borne positive de connexion et/ou des régions de court-circuit de surtensions (29b, 29c, 29d), côté borne négative de connexion, présente un dépôt de soudure.

10. Panneau solaire (1) comportant:
- au moins un module solaire (3) essentiellement en forme de plaque et
- au moins une boîte de jonction (7) selon l'une quelconque des revendications précédentes,
où le module solaire (3) comporte au moins deux conducteurs électriques (5a, 5b), lesquels sont reliés respectivement à un dispositif de contact électrique associé (13a, 13b) de la boîte de jonction (7).
